(19) Europäisches Patentamt

European Patent Office

Office européen des brevets

(11) **EP 3 662 093 B1**

(12) **EUROPEAN PATENT SPECIFICATION**

(45) Date of publication and mention
of the grant of the patent:
**05.10.2022 Bulletin 2022/40**

(21) Application number: **18733659.9**

(22) Date of filing: **03.07.2018**

(51) International Patent Classification (IPC):
$C23C\ 14/00^{(2006.01)}$   $C23C\ 14/06^{(2006.01)}$
$C23C\ 14/32^{(2006.01)}$   $C23C\ 30/00^{(2006.01)}$
$C23C\ 28/04^{(2006.01)}$   $C23C\ 14/34^{(2006.01)}$

(52) Cooperative Patent Classification (CPC):
**C23C 14/0676; C23C 14/0021; C23C 14/0641;
C23C 14/325; C23C 14/3414; C23C 28/042;
C23C 28/044; C23C 30/005**

(86) International application number:
**PCT/EP2018/067909**

(87) International publication number:
**WO 2019/025106 (07.02.2019 Gazette 2019/06)**

(54) **COATED CUTTING TOOL AND A PROCESS FOR ITS MANUFACTURE**

ALCRMEON-DECKSCHICHTEN

COUCHES DE REVÊTEMENT D'ALCRMEON

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **31.07.2017   EP 17184035**

(43) Date of publication of application:
**10.06.2020 Bulletin 2020/24**

(73) Proprietor: **Walter AG
72072 Tübingen (DE)**

(72) Inventors:
• **SCHIER, Veit
70771 Echterdingen (DE)**
• **DIECHLE, Dominic
71083 Herrenberg (DE)**

(74) Representative: **Sandvik
Sandvik Intellectual Property AB
811 81 Sandviken (SE)**

(56) References cited:
**JP-A- 2009 279 690     US-A1- 2008 131 727
US-A1- 2011 195 261**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**Field of the invention**

The present invention refers to a coated cutting tool comprising at least one AlCrMeON layer and an Arc-PVD process for manufacturing the same, the cutting tool exhibiting improved surface roughness properties and, at the same time, improved hardness and Young's modulus properties.

Cutting tools used, for example, for metal-machining in general consist of a base body (substrate) of cemented carbide (hard metal), cermet, steel or high-speed steel, having a wear-resistant layer or a multi-layer coating of hard metallic substances, oxide layers and the like deposited thereon. These coatings are applied using CVD (chemical vapour deposition) processes and/or PVD (physical vapour deposition) processes.

In regard to the PVD processes a distinction is drawn between various variants, including magnetron sputtering, arc vapour deposition (Arc-PVD), ion plating, electron beam vapour deposition and laser ablation. The target in the PVD process can comprise a pure metal or a combination of two or more metals. If the target includes a plurality of metals then all those metals are simultaneously incorporated into the layer of a coating, which is built up in the PVD process. The quantitative ratio of the metals relative to each other in the layer which is built up will depend on the quantitative ratio of the metals in the target, but also on the conditions in the PVD process, since individual metals may be removed from the target in higher quantities under given conditions and/or are deposited on the substrate in higher quantities than other metals.

To produce the desired metal compounds reactive gases are fed into the reaction chamber of the PVD process, for example nitrogen for producing nitrides, oxygen for producing oxides, carbonbearing compounds for producing carbides, carbonitrides, oxycarbides etc. or mixtures of those gases to produce corresponding mixed compounds.

Performing cathodic vacuum arc evaporation (Arc-PVD) an arc melting and evaporating the target material is ignited between the chamber and the target. In the process, a majority of the evaporated material is ionized, and, since an electrical field is established with a negative potential (bias potential) at the substrate, the ionized material is accelerated towards the substrate and is deposited on the substrate surface. The cathodic vacuum arc evaporation (Arc-PVD) is characterized by a high rate of deposition, by dense layer structures due to the high degree of ionization of the evaporated material, as well as by good process stability, in general. A substantial disadvantage of Arc-PVD is, however, the process-dependent deposition of macro particles (droplets) caused by the emission of small metal splashes, the avoidance of which is extremely complex. The droplets lead to an undesirably high surface roughness on the deposited layers.

Different variants of the deposition of AlCrON layers in an Arc-PVD process have been described in the prior art. It has been shown that it is possible to deposit AlCrON layers having different contents of O and N, while clearly, in general the deposition of the oxides of Al and Cr ($Al_2O_3$ and $Cr_2O_3$) is energetically preferred over the formation of the nitrides of Al and Cr (AlN and CrN). In other words, the enthalpy for formation ($\Delta H_B$) of the nitride phases is lower than the enthalpy for formation ($\Delta H_B$) of the oxide phases for Al and Cr over a wide range of temperatures. It has in general been shown that AlCrON layers, when having a higher content of N than of O, exhibit a good hardness and a dominant cubic phase. However, coated tools having coatings including such AlCrON layers have not in general proven to be particularly advantageous in metal cutting operations. Under certain conditions, AlCrON coatings comprising a higher content of oxygen have shown better wear resistance (see Khatibi A. et al., Acta Materialia 60 (2012) 6494-6507).

JP 2009279690 refers to a method for the production of a coated cutting tool, wherein the coating consists of $Al_aCr_bO_cN_d$, wherein a > b, (a+b) < (c+d) and wherein $16 \leq a \leq 29$, $3 \leq b \leq 17.5$, $57 \leq c \leq 67$, $0.5 \leq d \leq 7$ with a+b+c+d=100, and wherein during the coating procedure the ratio of the flow rate of oxygen gas (FRO) and the flow rate of nitrogen gas (FRN) is $0.02 \leq$ FRO/FRN $\leq 0.2$ and wherein the total gas pressure is in the range of 3 Pa to 15 Pa. Coatings obtained thereby have a relatively low content of N.

US2008131727 discloses an arc evaporation coating on a cutting tool with one layer of AlaCrbMecOdNe, wherein a, b, c, d, and e have the same atomic ratios as the application and represents the closest prior art.

Further, the deposition of AlO, AlCrO and AlCrON layers by magnetron sputtering was known in the prior art (e.g. Diechle et al., Surf. Coat. Technol., 206 (2011), 1545-1551 and Diechle et al., Surf. Coat. Technol., 204 (2010), 3258-3264). However, even though very smooth layers were obtained in these processes, in general, high temperatures and/or bias voltages are required in order to obtain a good crystallinity.

**Object of the Invention**

It is an object of the invention to provide AlCrON or AlCrMeON hard coating layers for metal cutting tools by arc vapor deposition (Arc-PVD) exhibiting a reduced droplet formation, reduced surface roughness, stabilized process conditions during production, and at the same time a high hardness and high Young's modulus E.

**Description of the invention**

According to the invention that object is attained by a process for manufacturing a coated cutting tool such as disclosed in claims 1-7.

In the following, the inventive coating layer $Al_aCr_bMe_cO_dN_e$ will also be referred to as "AlCrON or AlCrMeON" without indicating the indices a to e. For c = 0 the layer is an AlCrON layer, while in a layer of AlCrMeON c > 0, wherein Me is at least one element selected from the group consisting of Ti, Zr, Ta, Nb, Hf, Si, and V. The content of Me, relative to the total content of Al + Cr + Me, in the inventive AlCrMeON layer is $\leq$ 10 at-%, preferably $\leq$ 5 at-%, i.e. c / (a + b + c) $\leq$ 0.1, preferably $\leq$ 0.05. Even though the abbreviation "Me" is usually used for metals, in the sense of the present invention it is intended that it may include the element Si which is generally known as a semi-metal. If c > 0, i.e. the inventive coating layer $Al_aCr_bMe_cO_dN_e$ contains a certain amount of Me, it is preferred in the process of the invention that the targets containing Al and Cr, additionally contain the element or the elements representing Me in the amounts resulting in the deposition of Me in an atomic ratio corresponding to "c". However, Me can also be provided by one or more separate targets consisting of or containing Me, but not containing Al and/or Cr.

In a preferred embodiment of the process of the present invention, the reaction gas mixture consists only of $O_2$ gas and $N_2$ gas. In another embodiment of the process of the present invention, the reaction gas mixture consists of $O_2$ gas and $N_2$ gas and one or more inert gases, preferably one inert gas, which is then most preferably Ar. In yet another embodiment of the process of the present invention a portion or even all of the $O_2$ gas and a portion of the $N_2$ gas is replaced by a nitrogen and oxygen containing gas, selected from nitrous oxide, $N_2O$, nitric oxide, NO, nitrogen dioxide, $NO_2$, and dinitrogen tetroxide, $N_2O_4$, preferably the nitrogen and oxygen containing gas is nitrous oxide, $N_2O$.

The process of the present invention is defined by the oxygen flow rate, herein referred to as "flow rate ($O_2$)" and the nitrogen flow rate, herein referred to as "flow rate ($N_2$)". The oxygen and nitrogen flow rates are given in "sccm" = standard cubic centimeters per minute at the standard temperature of 0°C and the standard pressure of 1.01 bar = 101000 Pa. In the sense of the present invention the values indicated for the "flow rate ($O_2$)" and "flow rate ($N_2$)" take account for the molar amounts of oxygen and nitrogen provided by $O_2$ gas and $N_2$ gas in the reaction gas mixture. However, if a portion or even all of the $O_2$ gas and a portion of the $N_2$ gas is replaced by a nitrogen and oxygen containing gas, such as $N_2O$, as defined above, the herein indicated values of the "flow rate ($O_2$)" and the "flow rate ($N_2$)" have to be recalculated to take account for the amount of nitrogen and oxygen containing gas replacing $O_2$ and $N_2$ gas. For example, a flow rate of 50 sccm $O_2$ provides the same molar amount of oxygen as 100 sccm $N_2O$ gas in the reaction gas mixture. At the same time, 100 sccm $N_2O$ replaces 100 sccm of $N_2$ gas. Thus, a herein indicated "flow rate ($O_2$)" = 50 sccm and "flow rate ($N_2$)" = 4000 sccm would correspond to flow rates of 100 sccm $N_2O$ and 3900 sccm $N_2$.

If inert gas is present in the process of the present invention, the amount of inert gas should be low compared to the amounts of $N_2$ plus $O_2$. Therefore, the ratio of (flow rate ($O_2$) + flow rate ($N_2$)) / flow rate (inert gas) $\geq$ 4. For example, if the flow rate ($N_2$) is in the order of about 4000 sccm and the flow rate ($O_2$) is in the order of about 50 sccm the flow rate (inert gas) should not exceed a maximum of about 1012.5 sccm. If the amount of inert gas is too high, this may be at the expense of nitrogen in the reaction gas mixture at a certain total pressure of the reaction gas. And, if the amount of nitrogen becomes low, the roughness of the deposited AlCrMeON layer will undesirably increase. On the other hand, if the nitrogen flow is increased to compensate for the inert gas flow, the total gas pressure may become too high, exceeding 20 Pa, which in turn may lead to arc discharge at locations where discharge is not intended or desired.

It has been shown that by using the process of the present invention the mechanical properties, i.e. Vickers hardness as well as Young's modulus E, are improved over comparable coating layers prepared by sputtering techniques or other Arc-PVD methods applying different parameters and process conditions.

Compared to prior art processes for the deposition of AlCrON or AlCrMeON coatings, the process of the present invention uses a comparably high amount of nitrogen and a comparably low amount of oxygen in the reaction gas mixture. It was surprisingly found that the long-term process stability is improved compared to processes using Ar/$O_2$ reaction gas atmospheres or compared to Ar/$O_2$/$N_2$ reaction gas atmospheres having lower amounts of nitrogen. In particular, with respect to the targets used in the process, less poisoned areas are observed on the targets, which is an indication of a more even and homogeneous erosion of the targets in the inventive process compared to prior art processes. A great advantage of this process is that, after termination of the process, the targets used do not need to be conditioned, i.e. the targets remain conductive.

It has been found that the AlCrON or AlCrMeON layers deposited according to the inventive process consist of a single cubic phase, which is herein confirmed by XRD measurement. In particular, XRD of the layers obtained by the process according to the invention show a peak pattern similar to the cubic gamma phase of $Al_2O_3$ according to JCPD NO. 10-425 of the ICDD database, especially peaks similar to the (222) and (400) peaks of the gamma $Al_2O_3$. Thereby the positions of the peaks of the inventive layers may be shifted by some degrees 2-theta in the XRD compared to the peaks of gamma $Al_2O_3$ due to the incorporation of Cr and N into the lattice structure. Without being bound by theory, the inventors consider the inventive layers to consist of a metastable mixed-crystal single-phase. The XRD of the inventive layers shows a strong peak in the range of about 43-46 degrees 2-theta and a peak in the range of about 36-39 degrees 2-theta, which appear to correspond to the (400) and (222) peaks, respectively, of cubic gamma $Al_2O_3$.

The properties of the inventive coatings produced according to the inventive process are superior over the prior art and were surprising. From the composition of the reaction gas mixture of the inventive process containing a high content (partial pressure) of nitrogen and a very low content (partial pressure) of oxygen, even significantly lower than in JP 2009279690, one would expect coating layers of predominantly nitridic character. However, surprisingly the produced AlCrON or AlCrMeON layers exhibit a substantial oxidic character in that they show low electric conductivity and optical transparency. The optical transparency of the inventive layers is visible in general, and the transparent layers exhibit interference colors and thus a certain opalescence due to the relative low thickness.

At the same time, the inventive layers exhibit mechanical properties that are rather expected for nitridic coating layers, such as a high Vickers hardness HV0.015 $\geq$ 3000, or even HV0.015 $\geq$ 3200, and an increased reduced Young's modulus E $\geq$ 400 GPa, or even E $\geq$ 420 GPa. Even though the inventive process uses a very high content of nitrogen and a very low content of oxygen in the reaction gas mixture, the strong nitridic mechanical properties were surprising. From the observed significant oxidic properties, on one hand, and the high nitrogen content, on the other hand, one would expect that the coating layers consist of a mixture of oxide and nitride phases, i.e. that the typical mechanical properties of such phases would compensate each other to arrive at a middle level of comparably low Vickers hardness and low Young's modulus. However, it was surprisingly found in the XRD that the inventive coating layers are single-phase layers, and they surprisingly exhibit a combination only of the beneficial properties of oxidic and nitridic coating layers, i.e. high Vickers hardness and an high Young's modulus, and at the same time low electric conductivity. Without being bound by theory, the inventors assume that the single-phase of the coating layers of the present invention is a metastable phase.

The oxidic character, i.e. the low electric conductivity, is a beneficial property for coating layers of cutting tools, since low electric conductivity goes along with low thermal conductivity which shields and protects the substrate of the cutting tool from high heat generated during the cutting operation. Higher thermal shielding, i.e. lower thermal conductivity, allows to use the cutting tool for more demanding machining operations, such as applying higher cutting speed and higher cutting depths, machining of harder work piece materials, etc.

To illustrate the superior properties of the inventive coating layers, pure AlCr nitride exhibits high Vickers hardness HV0.015 in the order of about 3300 to 3500 and high Young's modulus in the order of about 400 to 450 GPa, but good electrical conductivity, i.e. high thermal conductivity, and no optical transparency. On the other hand, pure AlCr oxide exhibits low Vickers hardness HV0.015 in the order of about 2700 and low Young's modulus in the order of about 330 GPa, but low electrical conductivity, i.e. low thermal conductivity, and high optical transparency.

In process as used in the present invention the $O_2$ partial pressure can be measured by using a lambda-probe, whereas a direct measurement of the $N_2$ partial pressure is not possible. However, if only $O_2$ and $N_2$ are introduced, the $N_2$ partial pressure can be obtained by measuring the total pressure, and then the $N_2$ partial pressure is the difference between the total pressure and the $O_2$ partial pressure. In the process of the present invention it is observed that, at an early stage of the deposition process, the $O_2$ and $N_2$ partial pressures may change at constant $O_2$ and $N_2$ flows, due to the known phenomenon that, at the early stage of the process, oxidation processes occur at the oxidizable surfaces of parts of equipment within the reactor leading to a faster consumption of $O_2$ compared to $N_2$. Thus, while the oxidation process of the parts in the reactor advances and the unoxidized surface area of oxidizable parts in the reactor decreases, the $O_2$ partial pressure, and thus the total pressure, increase until the partial pressures of $O_2$ and $N_2$ become stable after a certain time, i.e. when the oxidation of the parts has reached an advanced stage, where no significant amounts of oxidizable parts of the reactor are left. It is observed that an essentially stabilized stage of the $O_2$ and $N_2$ partial pressures at constant flows is reached about 10 minutes after initiation of the process.

In this context it is to be mentioned that $O_2$ partial pressure indications in this invention mean the $O_2$ partial pressure at the stabilized stage of the process.

In an embodiment of the process according to the invention, it is desired to maintain the total pressure at a desired constant value, preferably in the order of about 10 Pa, and it is desired to maintain the $O_2$ flow at a desired constant value. Therefore, in this embodiment, the $N_2$ flow is adjusted (decreased) during the early stage of the deposition process in order to maintain the desired total pressure essentially constant, while the $O_2$ partial pressure increases at constant $O_2$ flow. In this embodiment the high $N_2$ partial pressure ensures that the preferred layers of AlCrMeNO are obtained, while regulating the $O_2$ flow is less laborious than regulating the $O_2$ partial pressure. Under these conditions, having a constant $O_2$ flow and a constant metal evaporation rate, the growth conditions for metal oxide are nearly constant through the process time. While there is not enough oxygen offered in the process to build pure metal oxide, the nitrogen covers the remaining "oxygen" positions in the lattice of the deposited layer. The reason why the oxygen is predominantly consumed during growth of the deposited layer is based on the different enthalpies of formation of metal nitrides and metal oxides.

The $O_2$ partial pressure is measured by means of a lambda oxygen sensor, which is positioned remote from the target. A position remote from the target essentially refers to a position at a distance from the target, preferably at a distance perpendicular to the target surface of at least 10 cm, more preferably the measurement is performed at the opposite side of the reaction chamber with respect to the target.

The total pressure of the gas in the reactor is measured by means of a Baratron® - Direct (Gas Independent) Pressure/Vacuum Capacitance Manometer, MKS Instruments.

In the inventive process, the gas inlet of the oxygen flow into the reactor is remote from the used targets and remote from the substrate. Preferably, the gas inlet of the oxygen flow is at or near the positions in the reactor where further targets may be positioned in the reactor, but which are not used for "active" targets in the process of the invention.

The AlCrON or AlCrMeON layer of the present invention may have a thickness in the range from 0.005 $\mu$m to 20 $\mu$m, however, the preferred thickness is from 0,05 $\mu$m to 1.5 $\mu$m. Too low thicknesses are difficult to produce, and the effect of the beneficial properties of the layer would not be realized. If the layer has a too large thickness, especially larger than 20 $\mu$m, the compressive residual stress of the layer will become too high leading to chipping and spalling of the layer and to impaired adhesion.

In an embodiment of the present invention, the $Al_aCr_bMe_cO_dN_e$ is deposited directly onto the surface of the substrate, and in another embodiment of the present invention, at least one base layer of a nitride, carbide, carbonitride or boride of an element, selected from the group, consisting of Ti, Al, Cr, Si, V, Nb, Ta, W, Zr and Hf, is deposited between the surface of the substrate and the $Al_aCr_b$-$Me_cO_dN_e$ layer. Such an at least one additional base layer between the substrate and the $Al_aCr_b$-$Me_cO_dN_e$ layer has been shown to increase the adhesion of the overall coating to the substrate. Preferred base layers are selected from the group, consisting of TiAlN, AlCrN, TiC, TiCN and $TiB_2$.

In an embodiment of the present invention, the $Al_aCr_bMe_cO_dN_e$ is the outermost layer of the coating of the coated cutting tool, and in another embodiment of the present invention, at least one further wear resistant and/or decorative layer of a nitride, carbide, carbonitride or boride of an element, selected from the group, consisting of Ti, Al, Cr, Si, V, Nb, Ta, W, Zr and Hf, is deposited on top of the $Al_aCr_bMe_cO_dN_e$ layer. Preferred layers are selected from the group, consisting of TiAlN, AlCrN, CrN, TiC, TiN, TiCN and $TiB_2$.

In an embodiment of the present invention, the coating of the coated cutting tool comprises two or more of the $Al_aCr_bMe_cO_dN_e$ layers, as defined herein and being deposited by the inventive deposition process. The two or more of the $Al_aCr_bMe_cO_dN_e$ layers may be deposited immediately on top of each other. However, in a preferred embodiment each of the two or more of the $Al_aCr_bMe_cO_dN_e$ layers is separated from the next of the two or more of the $Al_aCr_bMe_cO_dN_e$ layers by at least one separating layer of nitride, carbide, carbonitride or boride layer of one or more elements, selected from the group, consisting of Ti, Al, Cr, Si, V, Nb, Ta, W, Zr and Hf. A preferred layer sequence according to the present invention using the inventive $Al_aCr_bMe_cO_dN_e$ layers in combination with TiAlN layers is shown in the examples below.

In an embodiment of the process of the present invention the reaction gas mixture comprises, in addition to $O_2$ and $N_2$, an inert gas or a mixture of inert gases, preferably Ar. If inert gas is used, the amount, or the flow rate, respectively, is adjusted such that there is sufficient reactive gas remaining to achieve the beneficial properties of the inventive process.

In an embodiment of the process of the present invention the Al:Cr atomic ratio in the Arc-PVD targets is in the range of from 90:10 to 50:50, preferably of from 80:20 to 60:40. A suitable Al:Cr atomic ratio in the targets is about 70:30. These Al:Cr atomic ratios in the Arc-PVD targets have been shown to result in both the predominantly cubic phase having high hardness and high Young's modulus, as well as an oxidic behavior of the $Al_aCr_bMe_cO_dN_e$ layer. If the Al content is too high, the number and size of undesired droplets will increase. On the other hand, if the Cr content is too high, i.e. the Al:Cr ratio is too low, there is a tendency of formation of additional alpha phase of corundum structure leading to reduced hardness and Young's modulus.

In an embodiment of the process of the present invention the total gas pressure is $\geq$ 8 Pa, preferably $\geq$ 10 Pa and/or the total gas pressure is $\leq$15 Pa. It has surprisingly been found that this particular high total gas pressure, going along with a high $N_2$ partial pressure, ensures an improved extinction and re-ignition of the arc on the target surface. Furthermore, it is assumed that the high total pressure, i.e. high $N_2$ partial pressure, results in a particularly low $O_2$ partial pressure near the target surfaces, which in turn appears to contribute to the improved process stability and less poisoning of the targets and less droplet formation.

In an embodiment of the process of the present invention (flow rate ($O_2$) + flow rate ($N_2$)) / flow rate (inert gas) $\geq$ 5, preferably $\geq$ 8, or the reaction gas mixture contains no inert gas.

In an embodiment of the process of the present invention, the ratio of the overall evaporator current (measured in Ampere) to the $O_2$ flow (measured in sccm) is in the range of 15:1 to 6:1, preferably in the range of 14:1 to 10:1, or about 12:1. In the context of the present application, the term "overall evaporator current" means the sum of all evaporator currents at all targets used.

It has been shown that using a high ratio of overall evaporator current to oxygen flow, $Al_aCr_bMe_cO_dN_e$ layers are obtainable having a higher content of nitrogen than oxygen, and, these coating exhibit an extraordinarily high Vickers hardness and also an extraordinarily high Young's modulus, while the beneficial oxidic properties, i.e. low electric conductivity and optical transparency, are maintained.

In an embodiment of the process of the present invention, the bias voltage is in the range of 20 to 100 V. If the bias voltage is too high, the compressive residual stress of the deposited layer may become too high leading to an increased danger of chipping and spalling of the layer. If the bias voltage is too low, the hardness of the deposited layer will decrease drastically.

In an embodiment of the process of the present invention, the $O_2$ partial pressure is in the range of 0.01 to 0.1 Pa, preferably in the range of 0.01 to 0.02 Pa. If the $O_2$ partial pressure is too high, too much oxidation takes place at the target surface resulting in a loss of conductivity and the formation of two phases of conductive and non-conductive portions of material (non-conductive $\alpha$-$Al_2O_3$ and conductive Cr oxides). This, in turn leads to a higher degree of droplet formation, and thus, an increased roughness of the deposited layer. The process of the present invention produces smooth layers. If the $O_2$ partial pressure is too low, the deposited layers will no longer exhibit the desired oxidic properties, but only nitridic properties, as they have been described above.

The present invention also relates to a coated cutting tool consisting of a substrate and a single-layer or multi-layer hard material coating, the substrate being selected from cemented carbide, cermet, ceramics, cubic boron nitride (cBN), polycrystalline diamond (PCD) or high-speed steel (HSS), wherein the hard material coating comprises at least one layer of $Al_aCr_bMe_cO_dN_e$, wherein a, b, c, d, and e are atomic ratio and wherein

$$a + b + c + d + e = 1,$$

a, b, d and e each are > 0,
c = 0 or c > 0,
$a \geq b$,

$$c / (a + b + c) \leq 0.1$$

$$0.1 \leq d / (d + e) \leq 0.5$$

wherein Me is at least one element selected from the group consisting of Ti, Zr, Ta, Nb, Hf, Si, and V and the $Al_aCr_b$-$Me_cO_dN_e$ layer further having the following characteristics:

- a Vickers hardness HV 0.015 $\geq$ 3000
- a reduced Young's modulus E $\geq$ 400 GPa.

It has been shown that in the coated cutting tool according to the invention, despite the high content of N in the $Al_aCr_bMe_cO_dN_e$ layer, this layer still exhibits transparency, a low conductivity and at the same time a higher hardness and in particular higher Young's modulus E in comparison to other layers having a lower content of nitride compared to oxide. Preferably, the $Al_aCr_bMe_cO_dN_e$ layer of the present invention has a Vickers hardness HV 0.015 $\geq$ 3200 and/or a reduced Young's modulus E $\geq$ 420 GPa. Deposition of the $Al_aCr_bMe_cO_dN_e$ layer of the present invention is preferably carried out by means of the inventive Arc-PVD, as it is described herein.

In an embodiment of the present invention, in the $Al_aCr_bMe_cO_dN_e$ layer $0.05 \leq b / (a + b + c) \leq 0.5$, i.e. the Cr content in the layer is at least 5 at-% and not more than 50 at-% relative to the total content of Al + Cr + Me. If the Cr content is too low, an increased amount of droplets is observed resulting in an undesired roughness of the layer. The increased amount of droplet formation is considered to be due to fact that Al:Cr targets of high Al content and low Cr content have to be used in the deposition process to obtain a layer of a low Cr content. However, if the Cr content in the target is too low compared to the Al content, the target will quickly loose conductivity and process stability, and droplets will be generated. On the other hand, if the Cr content in the layer is too high, the formation of an additional phase of Cr oxide is observed going along with decreased Vickers hardness and Young's modulus.

In another embodiment of the present invention, in the $Al_aCr_bMe_cO_dN_e$ layer $2/3 \leq (a + b + c) / (d + e) \leq 1$, i.e. $0.5 \leq (d+e) \leq 0.6$ and $0.4 \leq (a+b+c) \leq 0,5$, since a+b+c+d+e = 1, promoting the formation of the beneficial properties of the inventive layer, which are assumed to be the result of the formation of a metastable cubic mixed single-phase.

In a further embodiment of the invention, the $Al_aCr_bMe_cO_dN_e$ layer has an average surface roughness Ra, measured over a length of 4.8 mm of $\leq$0.5 $\mu$m, preferably $\leq$0.1 $\mu$m. The surface roughness is measured with a roughness measuring device P800 type measuring system of the manufacturer JENOPTIK Industrial Metrology Germany GmbH (formerly Hommel-Etamic GmbH) using the evaluation software TURBO WAVE V7.32, determining the waviness according to ISO 11562, TKU300 sensing device and KE590GD test tip with a scan length of 4.8 mm and measured at a speed of 0.5 mm/ s.

The substrate of the coated cutting tool of the present invention may be selected from cemented carbide, cermet, ceramics, cubic boron nitride (cBN), polycrystalline diamond (PCD) and high-speed steel (HSS). In a preferred embodiment, the substrate is cemented carbide preferably having a composition of 6 to 14 wt% Co, optionally up to 10 wt% carbides or carbonitrides of one or more metals from groups 4, 5 and 6 of the periodic table of elements, and balance WC. The metals from groups 4, 5 and 6 are the periodic table of elements are suitably selected from the group consisting of Ti, Ta, Nb, V, Zr, Cr, W and Mo.

The average grain size of the WC, d, in the cemented carbide body is suitably in the range from 0.2 to 5 $\mu$m, preferably from 0.5 to 2 $\mu$m. The WC grain size in the cemented carbide substrate, d, is herein determined from the value of the measured magnetic coercitivity, and the relationship between the measured coercitivity and grain size of WC is described, e.g., in Roebuck et al., Measurement Good Practice No. 20, National Physical Laboratory, ISSN 1368-6550, November 1999, Revised February 2009, Section 3.4.3, pages 19-20. For coercitivity measurements it is referred to standard DIN IEC 60404-7. For the purposes of this application the grain size of the WC, d, is determined according to formula (8) on page 20 in the above-mentioned literature:

$$K=(c_1+d_1W_{Co})+ (c_2+d_2W_{Co})/d, \text{ i.e.}$$

$$d = (c_2+d_2W_{Co})/ (K-(c_1+d_1W_{Co})),$$

wherein

d= WC grain size of the cemented carbide body,
K= coercivity of the cemented carbide body in kA/m,
$W_{Co}$ = wt% Co in the cemented carbide body,
$c_1$= 1.44, $c_2$ = 12.47, $d_1$ = 0.04, and $d_2$ = -0.37.

The invention also relates to a coated cutting tool as described herein and being obtained in a process according to the invention. It has been found that the process of the present invention provides improved product properties to the coating, including high hardness and Young's modulus, and it has turned out that the coated cutting tool produced according to the process of the invention exhibits superior cutting properties in metal machining.

Further advantages, features and embodiments of the present invention are described by reference to the following examples and figure.

**Figure Description**

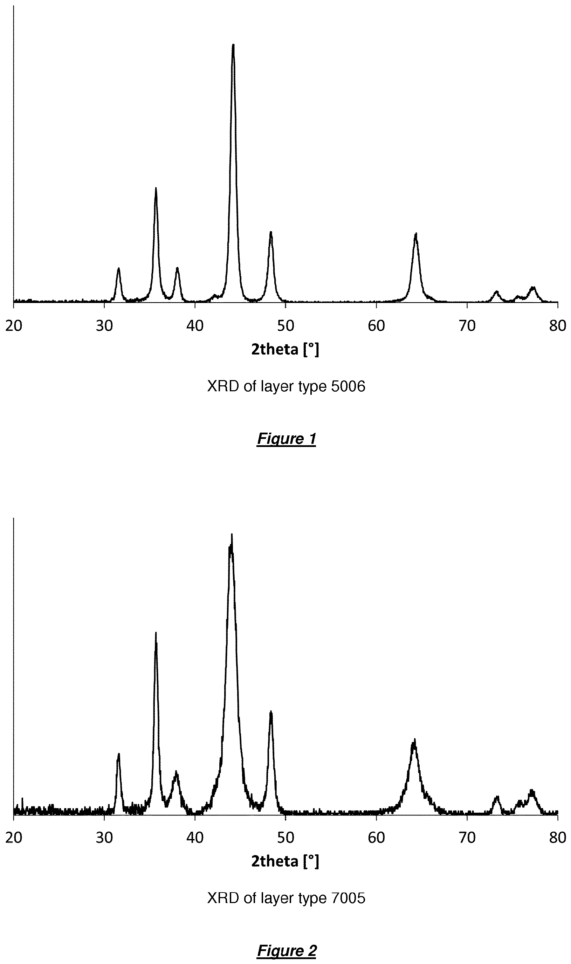

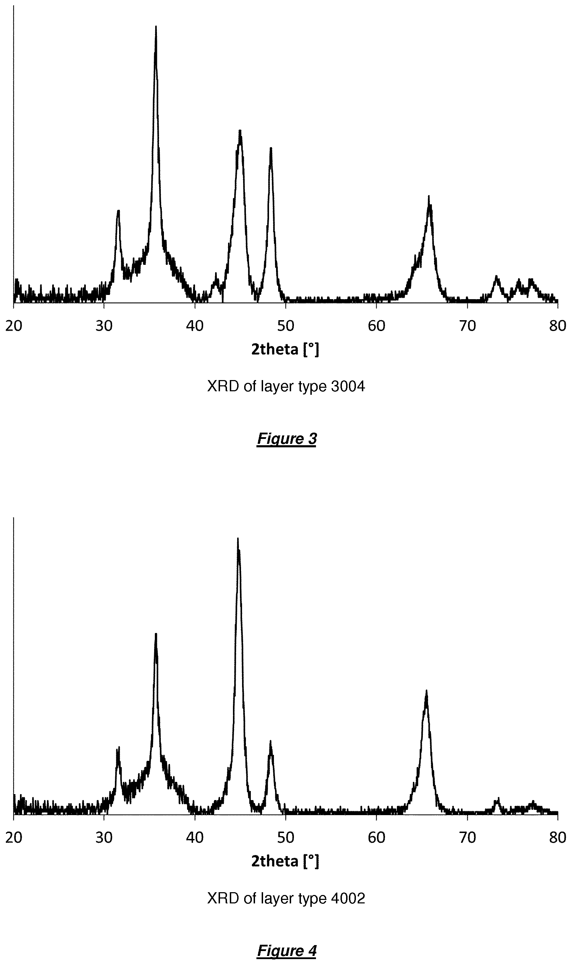

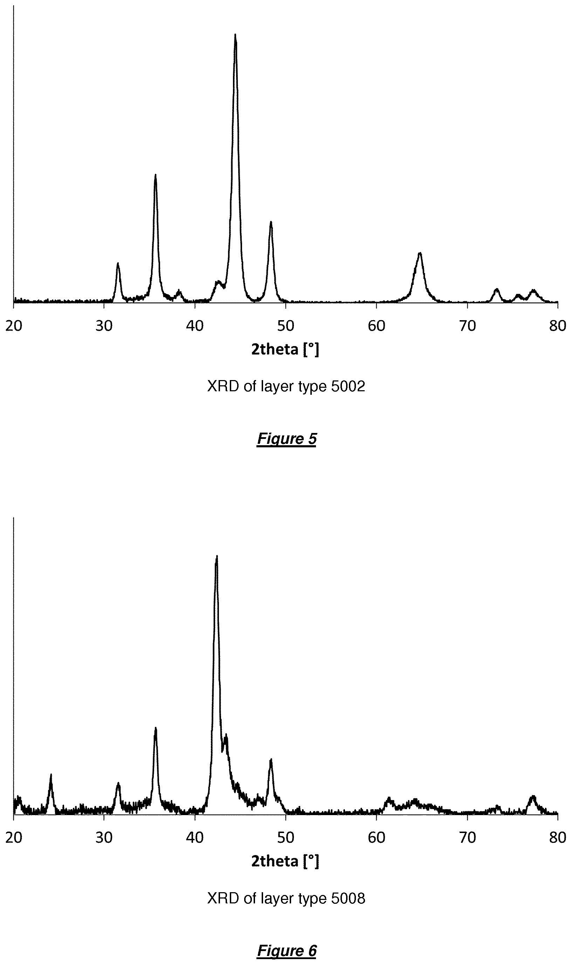

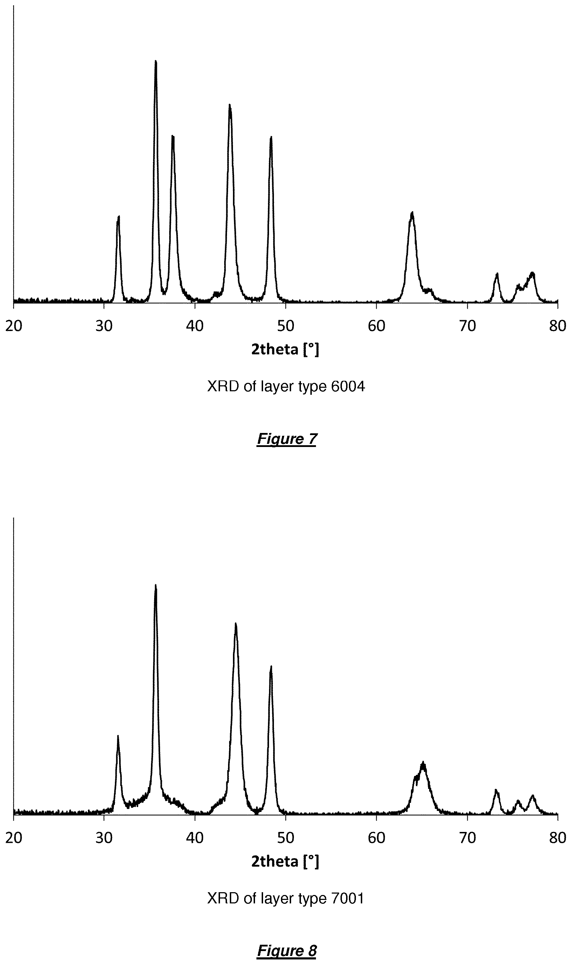

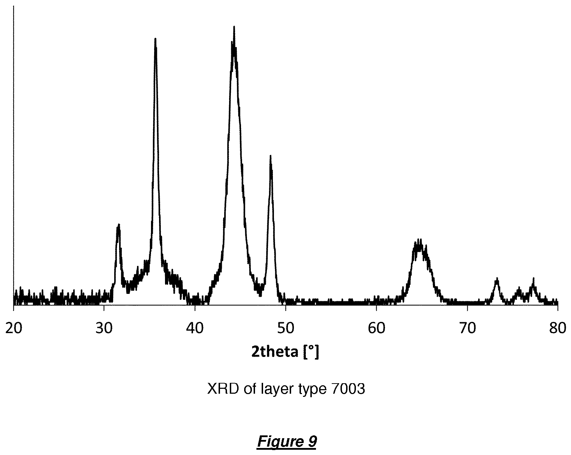

Figures 1 to 9 show XRD diffractograms of the layer types produced and investigated according to the following examples.

**Materials and Methods**

For characterizing the deposited layers of the examples and comparative examples described herein, the following methods were used.

XRD (X-ray diffraction)

XRD measurements were done on a XRD3003 PTS diffractometer of GE Sensing and Inspection Technologies using CuK$\alpha$-radiation. The X-ray tube was run in point focus at 40 kV and 40 mA. A parallel beam optic using a polycapillary collimating lens with a measuring aperture of fixed size was used on the primary side whereby the irradiated area of the sample was defined in such manner that a spill over of the X-ray beam over the coated face of the sample is avoided. On the secondary side a Soller slit with a divergence of 0.4° and a 25 $\mu$m thick Ni $K_\beta$ filter were used. The measurements were carried out over the range of 15 to 80° 2-theta with a step size of 0,03°. Grazing-incidence X-ray diffraction technique under 1° incidence angel was employed to study the crystal structure of the layers.

Vickers hardness:

The Vickers hardness was measured by means of nano indentation (load-depth graph) using a Picodentor HM500 of Helmut Fischer GmbH, Sindelfingen, Germany. For the measurement and calculation the Oliver and Pharr evaluation algorithm was applied, wherein a diamond test body according to Vickers was pressed into the layer and the force-path curve was recorded during the measurement. The maximum load used was 15 mN, the time period for load increase and load decrease was 20 seconds each and the holding time (creep time) was 10 seconds. From this curve hardness was calculated.

### Reduced Young's modulus

The reduced Young's modulus (modulus of elasticity) was determined by means of nano-indentation (load-depth graph) as described for determining the Vickers hardness.

### Thickness:

Thickness was determined by calotte grinding. Thereby a steel ball was used having a diameter of 30 mm for grinding the dome shaped recess and further the ring diameters were measured, and the layer thicknesses were calculated therefrom.

### EDX (Energy-dispersive X-ray spectroscopy)

EDX measurements for atomic content determination within the layer were carried out on a scanning electron microscope Supra 40 VP from Carl Zeiss at 15 kV acceleration voltage with an EDX spectrometer of the type INCA x-act from Oxford Instruments, UK.

### PVD Coating

For PVD coatings, as described in the examples herein, a Hauzer HTC1000 (IHI Hauzer Techno Coating B.V., The Netherlands) was used applying a circular arc technology (CARC+) using constant magnetic field configuration during deposition.

### Surface roughness

Average surface roughness, Ra, was measured with a roughness measuring device P800 type measuring system of the manufacturer JENOPTIK Industrial Metrology Germany GmbH (formerly Hommel-Etamic GmbH) using the evaluation software TURBO WAVE V7.32, determining the waviness according to ISO 11562, TKU300 sensing device and KE590GD test tip with a scan length of 4.8 mm and measured at a speed of 0.5 mm/ s.

### Examples

Example 1 - Deposition of AlCrON coating layers according to the invention and comparative coatings

In the following examples of the preparation of cutting tools according to the present invention and of comparative examples cemented carbide cutting tool substrate bodies (composition: 12 wt-% Co, 1.6 wt-% (Ta, Nb)C, balance WC; WC grain size: 1.5 $\mu$m geometry: ADMT160608R-F56) were coated in a PVD system as indicated above.

Prior to the deposition, the installation was evacuated to $8 \times 10^{-5}$ mbar, and the substrate was pretreated at 550°C.

For the deposition of AlCrON layers in each case 4 targets having an Al:Cr atomic ratio of 70:30, having a diameter of 100 mm and being positioned in the reactor on top of each other were used. The further parameters for the deposition of different layers are given in the following table 1. Thereby, the indicated $O_2$ partial pressure and the indicated $N_2$ flow are the ones 10 min after initiation of the deposition process. In the deposition of layer type 5008 no Ar, instead of $N_2$, was used to obtain the desired total pressure.

Table 1

| Layer Type | N2 flow [sccm] | $O_2$ flow [sccm] | Overall current [A] | Time [min] | Bias current [A] | Bias voltage [V] | $O_2$ partial pressure [Pa] | Total pressure [Pa] |
|---|---|---|---|---|---|---|---|---|
| 3004 (Comp.) | 3950 | 360 | 4x150 | 60 | 3.9 | 40 | 0.11 | 10 ($N_2$) |
| 4002 (Comp.) | 4090 | 200 | 4x150 | 60 | 4.9 | 40 | 0.11 | 10 ($N_2$) |
| 5002 (Comp.) | 4180 | 100 | 4x150 | 60 | 4.9 | 40 | 0.047 | 10 ($N_2$) |

(continued)

| Layer Type | N2 flow [sccm] | O₂ flow [sccm] | Overall current [A] | Time [min] | Bias current [A] | Bias voltage [V] | O₂ partial pressure [Pa] | Total pressure [Pa] |
|---|---|---|---|---|---|---|---|---|
| 5006 (Inv.) | 4180 | 50 | 4x150 | 60 | 4.8 | 40 | 0.017 | 10 (N₂) |
| 5008 (Comp.) | --- | 170 | 4x150 | 60 | 7.7 | 40 | 0.11 | 10 (Ar) |
| 6004 (Comp.) | 4210 | --- | 4x150 | 60 | 4.5 | 40 | --- | 10 (N₂) |
| 7001 (Comp.) | 4080 | 200 | 4x150 | 60 | 5.8 | 80 | 0.11 | 10 (N₂) |
| 7003 (Comp.) | 4050 | 200 | 4x150 | 60 | 6.3 | 120 | 0.12 | 10 (N₂) |
| 7005 (Inv.) | 4170 | 50 | 4x150 | 60 | 5.5 | 80 | 0.017 | 10 (N₂) |

During the deposition, the $O_2$ flow was kept constant, while the indicated $O_2$ partial pressure was reached during the process. The total pressure was kept constant at 10 Pa by adjusting the flow of $N_2$ or Ar, respectively. In these examples, either $N_2$ or Ar were used, but no mixtures.

Table 2 shows the thickness, the Vickers hardness, the reduced Young's modulus and the atomic contents of the deposited layers, measured as described above.

Table 2

| Layer Type | Layer thickness [µm] | Vickers hardness [HV0.015] | reduced Young's modulus [GPa] | Al [at. %] | Cr [at. %] | O [at. %] | N [at. %] |
|---|---|---|---|---|---|---|---|
| 3004 (Comp.) | 1.20 | 2755 | 354 | 25.3 | 12.7 | 62.1 | 0.0 |
| 4002 (Comp.) | 1.40 | 2828 | 339 | 27.2 | 14.3 | 54.3 | 4.3 |
| 5002 (Comp.) | 1.40 | 3301 | 379 | 27.6 | 15.1 | 31.3 | 26.1 |
| 5006 (Inv.) | 1.40 | 3387 | 433 | 28.8 | 15.7 | 16.7 | 38.9 |
| 5008 (Comp.) | 2.00 | 987 | 226 | 29.4 | 14.3 | 56.3 | 0.0 |
| 6004 (Comp.) | 1.40 | 2905 | 460 | 30.6 | 17.6 | 1.7 | 50.1 |
| 7001 (Comp.) | 1.60 | 3010 | 361 | 25.7 | 13.3 | 52.9 | 8.0 |
| 7003 (Comp.) | 1.60 | 2507 | 299 | 24.4 | 12.8 | 53.4 | 9.4 |
| 7005 (Inv.) | 1.05 | 3515 | 421 | 28.5 | 16.1 | 16.7 | 38.7 |

XRD measurements were made on all layer types and are shown in figures 1 to 9. The diffractograms show that each of the AlCrON layers according to the present invention exhibit only one single cubic phase.
The surface roughness was measured on an AlCrON layer according to the invention (Layer Type 7005). The average surface roughness Ra, measured over a length of 4.8 mm, was 0.03 $\mu$m.

Example 2 - Cutting tests on multi-layer coated cutting tools

In order to assess the effect of the AlCrON layer according to the invention, compared to conventional coating, with respect to cutting properties, multi-layer coated cutting tools were produced and tested in a milling test. The cemented carbide substrates were the same as used above in example 1. In each case the multi-layer coating structures consisted of a total of seven layers, four of them were conventional TiAlN layers, alternating with inventive AlCrON layers in the tool according to the invention, or with $Al_2O_3$ layers in the comparative tool. The thicknesses of the layers corresponding to each other were the same in both sequences.

The TiAlN layers were each deposited in an Arc-PVD process at a total pressure of 10 Pa. The ratio Al/(Al+Ti) in the layers was 0.61 with 50 at.% nitrogen. The deposition conditions were adjusted to achieve the desired layer thicknesses.

The AlCrON layers in the layer sequence of the tool according to the invention were deposited under the deposition conditions as describe above for layer type 5006, whereby the deposition times were adjusted to achieve the desired layer thicknesses.

The $Al_2O_3$ layers in the comparative tool were prepared by dual magnetron sputtering at a 20 kW, a total gas pressure of 0.45 Pa, an Ar flow of 500 sccm, an $O_2$ flow of about 125 sccm, at a bias voltage of 125 V, pulsed with 40 kHz and 10 $\mu$s off time and 22 A bias current as well as 480 V cathode voltage after hysteresis (at the operating point).

The layer structures were as follows:

| Layer # (from substrate) | Layer Th ickness [$\mu$m] | Layer Composition Inventive Tool | Layer Composition Comparative Tool |
|---|---|---|---|
| 1 | 4 $\mu$m | TiAlN | |
| 2 | 0.5 $\mu$m | AlCrNO | $Al_2O_3$ |
| 3 | 0.25 $\mu$m | TiAlN | |
| 4 | 0.1 $\mu$m | AlCrNO | $Al_2O_3$ |
| 5 | 0.25 $\mu$m | TiAlN | |
| 6 | 0.1 $\mu$m | AlCrNO | $Al_2O_3$ |
| 7 | 0.6 $\mu$m | TiAlN | |

Cutting tests were performed on a Heller FH 120-2 machine under the following conditions.

Cutting conditions:

| | |
|---|---|
| Tooth Feed $f_z$ [mm/tooth]: | 0.2 |
| Feed $v_f$ [mm/min]: | 120 |
| Cutting speed $v_c$ [m/min]: | 235 |
| Cutting depth $a_p$ [mm]: | 3 |
| Workpiece material : | 42CrMo4; tensile strength Rm: 950 N/mm$^2$ |

The following table 3 shows the results of the cutting tests, wherein $V_B$ is the minimum wear at the flank faces of the tool, $V_{Bmax}$ is the maximum wear, i.e. the deepest crater observed on the flank face of a tool, and $V_R$ is the wear at the cutting edge radius

Table 3

| | Inventive Tool | | | Comparative Tool | | |
|---|---|---|---|---|---|---|
| Cutting length [mm] | VB [mm] | VBmax [mm] | VR [mm] | VB [mm] | VBmax [mm] | VR [mm] |
| 800 | 0.02 | 0.02 | 0.02 | 0.02 | 0.03 | 0.03 |

(continued)

| Cutting length [mm] | Inventive Tool | | | Comparative Tool | | |
|---|---|---|---|---|---|---|
| | VB [mm] | VBmax [mm] | VR [mm] | VB [mm] | VBmax [mm] | VR [mm] |
| 1600 | 0.02 | 0.02 | 0.02 | 0.03 | 0.04 | 0.06 |
| 2400 | 0.02 | 0.02 | 0.03 | 0.04 | 0.06 | 0.08 |
| 3200 | 0.02 | 0.03 | 0.03 | 0.07 | 0.10 | 0.12 |
| 4000 | 0.02 | 0.03 | 0.04 | 0.10 | 0.12 | 0.17 |
| 4800 | 0.02 | 0.06 | 0.08 | 0.12 | 0.35 | 0.45 |

In particular over a longer cutting length, the cutting tool coated with layer sequence, comprising an AlCrON layer according to the invention shows a significant reduction of the wear, both at the flank face and the cutting edge radius, in comparison to a similar layer sequence, comprising $Al_2O_3$ layers instead of the AlCrON layers according to the invention.

## Claims

1. A process for manufacturing a coated cutting tool consisting of a substrate and a single-layer or multi-layer hard material coating, the substrate being selected from cemented carbide, cermet, ceramics, cubic boron nitride (cBN), polycrystalline diamond (PCD) or high-speed steel (HSS), and the hard coating comprising at least one layer of $Al_aCr_bMe_cO_dN_e$, wherein a, b, c, d, and e are atomic ratios, and wherein

$$a + b + c + d + e = 1,$$

a, b, d and e each are > 0,
c = 0 or c > 0,
$a \geq b$,

$$c / (a + b + c) \leq 0.1,$$

preferably $\leq 0.05$

$$0.1 \leq d / (d + e) \leq 0.5,$$

wherein Me is at least one element selected from the group consisting of Ti, Zr, Ta, Nb, Hf, Si, and V and wherein the $Al_aCr_bMe_cO_dN_e$ layer is deposited by an arc vapor deposition process (Arc-PVD) using targets containing Al and Cr with an Al:Cr atomic ratio in the range of 95:5 to 50:50, and wherein

- the reaction gas mixture contains $O_2$ gas and $N_2$ gas, wherein optionally a portion or all of the $O_2$ gas and a portion of the $N_2$ gas is replaced by a nitrogen and oxygen containing gas, selected from nitrous oxide, $N_2O$, nitric oxide, NO, nitrogen dioxide, $NO_2$, and dinitrogen tetroxide, $N_2O_4$,
- the reaction gas mixture optionally contains one or more inert gases,
- the total gas pressure is within the range from 7 Pa to 15 Pa,
- the $O_2$ partial pressure is at a stabilized stage of the process and is from 0.001 Pa to 0.1 Pa,
- $0.002 \leq$ (flow rate ($O_2$) / flow rate ($N_2$) $\leq 0.02$, at an essentially stabilized stage of the $O_2$ and $N_2$ partial pressures at constant flows,
- (flow rate ($O_2$) + flow rate ($N_2$)) / flow rate (inert gas) $\geq 4$, at an essentially stabilized stage of the $O_2$ and $N_2$ partial pressures at constant flows,
- if replacing a portion of $O_2$ gas and/or $N_2$ gas by a nitrogen and oxygen containing gas, selected from nitrous oxide, $N_2O$, nitric oxide, NO, nitrogen dioxide, $NO_2$, and dinitrogen tetroxide, $N_2O_4$, the values for the flow rate ($O_2$) and the flow rate ($N_2$) are recalculated by taking into account the molar amounts of oxygen and nitrogen in the replacing gas.

2. The process according to claim 1, wherein the Al:Cr atomic ratio in the target(s) is in the range of 90:10 to 50:50, preferably in the range of 80:20 to 60:40.

3. The process according to any one of claims 1 and 2, wherein the total gas pressure is $\geq 8$ Pa, preferably $\geq 10$ Pa and the total gas pressure is $\leq 15$ Pa.

4. The process according to any one of the preceding claims, wherein (flow rate ($O_2$) + flow rate ($N_2$)) / flow rate (inert gas) $\geq 5$, preferably $\geq 8$, or the reaction gas mixture contains no inert gas.

5. The process according to any one of the preceding claims, wherein the ratio of overall evaporator current, measured in Ampere, to $O_2$ flow, measured in sccm, is in the range of 15:1 to 6:1, preferably in the range of 14:1 to 10:1.

6. The process according to any one of the preceding claims, wherein the bias voltage is in the range of 20 to 100 V.

7. The process according to any one of the preceding claim, wherein the $O_2$ partial pressure is in the range of 0.01 to 0.1 Pa, preferably in the range of 0.01 to 0.02 Pa.

8. A coated cutting tool consisting of a substrate and a single-layer or multi-layer hard material coating, the substrate being selected from cemented carbide, cermet, ceramics, cubic boron nitride (cBN), polycrystalline diamond (PCD) or high-speed steel (HSS), wherein the hard material coating comprises at least one layer of $Al_aCr_bMe_cO_dN_e$, wherein a, b, c, d, and e are atomic ratio and wherein

    i)

$$a + b + c + d + e = 1,$$

    ii) a, b, d and e each are > 0,
    iii) c = 0 or c > 0,
    iv) a $\geq$ b,
    v)

$$c / (a + b + c) \leq 0.1$$

    vi)

$$0.1 \leq d / (d + e) \leq 0.5$$

wherein Me is at least one element selected from the group consisting of Ti, Zr, Ta, Nb, Hf, Si, and V and the $Al_aCr_bMe_cO_dN_e$ layer further having the following characteristics:

    - a Vickers hardness HV 0.015 $\geq$ 3000
    - a reduced Young's modulus E $\geq$ 400 GPa.

9. The coated cutting tool according to claim 8, wherein

$$0.05 \leq b / (a + b + c) \leq 0.5.$$

10. The coated cutting tool according to any one of claims 8 and 9, wherein

$$2/3 \leq (a + b + c) / (d + e) \leq 1.$$

**11.** The coated cutting tool according to any one of claims 8 to 10, wherein the $Al_aCr_bMe_{-c}O_dN_e$ layer has a Vickers hardness HV 0.015 ≥ 3200.

**12.** The coated cutting tool according to any one of claims 8 to 11, wherein the $Al_aCr_bMe_{-c}O_dN_e$ layer has a reduced Young's modulus E ≥ 420 GPa.

**13.** The coated cutting tool according to any one of claims 8 to 12, wherein the $Al_aCr_bMe_cO_dN_e$ layer has an average surface roughness Ra, measured over a length of 4.8 mm of ≤0.5 $\mu$m, preferably ≤0.1 $\mu$m.

**14.** The coated cutting tool of any one of claims 8 to 13, obtained in a process according to any one of claims 1 to 7.


**Patentansprüche**

**1.** Verfahren zum Herstellen eines beschichteten Schneidwerkzeugs, bestehend aus einem Substrat und einer einschichtigen oder mehrschichtigen Hartstoffbeschichtung, wobei das Substrat aus Hartmetall, Cermet, Keramik, kubischem Bornitrid (cBN), polykristallinem Diamant (PCD) oder Schnellarbeitsstahl (HSS) ausgewählt ist, und wobei die Hartbeschichtung mindestens eine Schicht aus $Al_aCr_bMe_cO_dN_e$ umfasst, wobei a, b, c, d und e Atomverhältnisse sind, und wobei

$$a + b + c + d + e = 1,$$

a, b, d und e jeweils > 0 sind,
c = 0 oder c > 0,
a ≥ b,

$$c / (a + b + c) \leq 0{,}1,$$

vorzugsweise ≤ 0,05,

$$0{,}1 \leq d / (d + e) \leq 0{,}5,$$

wobei Me mindestens ein Element ist, ausgewählt aus der Gruppe bestehend aus Ti, Zr, Ta, Nb, Hf, Si und V, und wobei die $Al_aCr_bMe_cO_dN_e$-Schicht durch ein Lichtbogen-Dampfabscheidungsverfahren (Arc-PVD) unter Verwendung von Targets abgeschieden wird, die Al und Cr mit einem Atomverhältnis Al:Cr im Bereich von 95:5 bis 50:50 enthalten, und wobei

- das Reaktionsgasgemisch $O_2$-Gas und $N_2$-Gas enthält, wobei optional ein Teil oder das gesamte $O_2$-Gàs und ein Teil des $N_2$-Gases durch ein stickstoff- und sauerstoffhaltiges Gas, ausgewählt aus Distickstoffoxid, $N_2O$, Stickstoffmonoxid, NO, Stickstoffdioxid, $NO_2$, und Distickstofftetroxid, $N_2O_4$, ersetzt wird,
- das Reaktionsgasgemisch optional ein oder mehrere Inertgase enthält,
- der Gesamtgasdruck im Bereich von 7 Pa bis 15 Pa liegt,
- der $O_2$-Partialdruck in einer stabilisierten Stufe des Verfahrens liegt und zwischen 0,001 Pa bis 0,1 Pa beträgt,
- 0,002 ≤ (Durchflussrate ($O_2$) / Durchflussrate ($N_2$) ≤ 0,02, in einer im Wesentlichen stabilisierten Stufe der $O_2$- und $N_2$-Partialdrücke bei konstanten Durchflüssen,
- (Durchflussrate ($O_2$) + Durchflussrate ($N_2$)) / Durchflussrate (Inertgas) ≥ 4, in einer im Wesentlichen stabilisierten Stufe der $O_2$- und $N_2$-Partialdrücke bei konstanten Durchflüssen,
- wenn ein Teil des $O_2$-Gases und/oder $N_2$-Gases durch ein stickstoff- und sauerstoffhaltiges Gas, ausgewählt aus Distickstoffoxid, $N_2O$, Stickstoffmonoxid, NO, Stickstoffdioxid, $NO_2$, und Distickstofftetroxid, $N_2O_4$, ersetzt wird, die Werte für die Durchflussrate ($O_2$) und die Durchflussrate ($N_2$) unter Berücksichtigung der molaren Mengen an Sauerstoff und Sauerstoff in dem Ersatzgas neu berechnet werden.

**2.** Verfahren nach Anspruch 1, wobei das Atomverhältnis Al:Cr in dem/den Target(s) im Bereich von 90:10 bis 50:50, vorzugsweise im Bereich von 80:20 bis 60:40, liegt.

3. Verfahren nach einem der Ansprüche 1 und 2, wobei der Gesamtgasdruck $\geq$ 8 Pa, vorzugsweise $\geq$ 10 Pa, und der Gesamtgasdruck $\leq$ 15 Pa beträgt.

4. Verfahren nach einem der vorhergehenden Ansprüche, wobei (Durchflussrate ($O_2$) + Durchflussrate ($N_2$)) / Durchflussrate (Inertgas) $\geq$ 5, vorzugsweise $\geq$ 8, oder das Reaktionsgasgemisch kein Inertgas enthält.

5. Verfahren nach einem der vorhergehenden Ansprüche, wobei das Verhältnis des Gesamtverdampferstroms, gemessen in Ampere, zum $O_2$-Durchfluss, gemessen in sccm, im Bereich von 15:1 bis 6:1, vorzugsweise im Bereich von 14:1 bis 10:1, liegt.

6. Verfahren nach einem der vorhergehenden Ansprüche, wobei die Vorspannung im Bereich von 20 bis 100 V liegt.

7. Verfahren nach einem der vorhergehenden Ansprüche, wobei der $O_2$-Partialdruck im Bereich von 0,01 bis 0,1 Pa, vorzugsweise im Bereich von 0,01 bis 0,02 Pa, liegt.

8. Beschichtetes Schneidwerkzeug, bestehend aus einem Substrat und einer einschichtigen oder mehrschichtigen Hartstoffbeschichtung, wobei das Substrat aus Hartmetall, Cermet, Keramik, kubischem Bornitrid (cBN), polykristallinem Diamant (PCD) oder Schnellarbeitsstahl (HSS) ausgewählt ist, wobei die Hartstoffbeschichtung mindestens eine Schicht aus $Al_aCr_bMe_cO_dN_e$ umfasst, wobei a, b, c, d und e ein Atomverhältnis sind, und wobei

i)

$$a + b + c + d + e = 1,$$

ii) a, b, d und e jeweils > 0 sind,
iii) c = 0 oder c > 0,
iv) a $\geq$ b,
v)

$$c / (a + b + c) \leq 0,1,$$

vi)

$$0,1 \leq d / (d + e) \leq 0,5,$$

wobei Me mindestens ein Element ist, ausgewählt aus der Gruppe bestehend aus Ti, Zr, Ta, Nb, Hf, Si und V, und die $Al_aCr_bMe_cO_dN_e$-Schicht ferner die folgenden Eigenschaften aufweist:

- eine Vickers-Härte HV 0,015 von $\geq$ 3000,
- einen reduzierten Elastizitätsmodul E von $\geq$ 400 GPa.

9. Beschichtetes Schneidwerkzeug nach Anspruch 8, wobei

$$0,05 \leq b / (a + b + c) \leq 0,5.$$

10. Beschichtetes Schneidwerkzeug nach einem der Ansprüche 8 und 9, wobei

$$2 / 3 \leq (a + b + c) / (d + e) \leq 1.$$

11. Beschichtetes Schneidwerkzeug nach einem der Ansprüche 8 bis 10, wobei die $Al_aCr_bMe_cO_dN_e$-Schicht eine Vickers-Härte HV 0,015 von $\geq$ 3200 aufweist.

12. Beschichtetes Schneidwerkzeug nach einem der Ansprüche 8 bis 11, wobei die $Al_aCr_bMe_cO_dN_e$-Schicht einen

reduzierten Elastizitätsmodul E ≥ 420 GPa aufweist.

13. Beschichtetes Schneidwerkzeug nach einem der Ansprüche 8 bis 12, wobei die $Al_aCr_bMe_cO_dN_e$-Schicht eine durchschnittliche Oberflächenrauigkeit Ra, gemessen über eine Länge von 4,8 mm, von ≤ 0,5 μm, vorzugsweise ≤ 0,1 μm, aufweist.

14. Beschichtetes Schneidwerkzeug nach einem der Ansprüche 8 bis 13, das in einem Verfahren nach einem der Ansprüche 1 bis 7 erhalten wurde.

**Revendications**

1. Procédé de fabrication d'un outil de coupe revêtu constitué d'un substrat et d'un revêtement de matériau dur monocouche ou multicouche, le substrat étant choisi parmi le carbure cémenté, le cermet, les céramiques, le nitrure de bore cubique (cBN), le diamant polycristallin (PCD) ou l'acier rapide (HSS), et le revêtement dur comprenant au moins une couche de $Al_aCr_bMe_cO_dN_e$, dans lequel a, b, c, d et e sont des rapports atomiques, et dans lequel

$$a + b + c + d + e = 1,$$

a, b, d et e sont chacun > 0,
c = 0 ou c > 0,
a ≥ b,

$$c / (a + b + c) \le 0,1,$$

de préférence ≤ 0,05

$$0,1 \le d / (d + e) \le 0,5,$$

dans lequel Me est au moins un élément choisi dans le groupe constitué par Ti, Zr, Ta, Nb, Hf, Si et V et dans lequel la couche de $Al_aCr_bMe_cO_dN_e$ est déposée par un procédé de dépôt en phase vapeur (Arc-PVD) à l'arc à l'aide de cibles contenant Al et Cr à un rapport atomique Al:Cr dans la plage de 95:5 à 50:50, et dans lequel

- le mélange gazeux réactionnel contient du gaz $O_2$ et du gaz $N_2$, dans lequel éventuellement une partie ou la totalité du gaz $O_2$ et une partie du gaz $N_2$ sont remplacées par un gaz contenant de l'azote et de l'oxygène, choisi parmi l'oxyde nitreux, $N_2O$, l'oxyde nitrique, NO, le dioxyde d'azote, $NO_2$, et le tétraoxyde de diazote, $N_2O_4$,
- le mélange gazeux réactionnel contient éventuellement un ou plusieurs gaz inertes,
- la pression de gaz totale se situe dans la plage de 7 Pa à 15 Pa,
- la pression partielle de $O_2$ est à un stade stabilisé du procédé et est de 0,001 Pa à 0,1 Pa,
- 0,002 ≤ (débit ($O_2$) / débit ($N_2$) ≤ 0,02, à un stade essentiellement stabilisé des pressions partielles de $O_2$ et $N_2$ à débits constants,
- (débit ($O_2$) + débit ($N_2$)) / débit (gaz inerte) ≥ 4, à un stade essentiellement stabilisé des pressions partielles de $O_2$ et $N_2$ à débits constants,
- si l'on remplace une partie du gaz $O_2$ et/ou du gaz $N_2$ par un gaz contenant de l'azote et de l'oxygène, choisi parmi l'oxyde nitreux, $N_2O$, l'oxyde nitrique, NO, le dioxyde d'azote, $NO_2$ et le tétraoxyde de diazote, $N_2O_4$, les valeurs pour le débit ($O_2$) et le débit ($N_2$) sont recalculées compte tenu des quantités molaires d'oxygène et d'azote dans le gaz de remplacement.

2. Procédé selon la revendication 1, dans lequel le rapport atomique Al:Cr dans la(les) cible(s) est dans la plage de 90:10 à 50:50, de préférence dans la plage de 80:20 à 60:40.

3. Procédé selon l'une quelconque des revendications 1 et 2, dans lequel la pression de gaz totale est ≥ 8 Pa, de préférence ≥ 10 Pa et la pression de gaz totale est ≤ 15 Pa.

**4.** Procédé selon l'une quelconque des revendications précédentes, dans lequel (débit ($O_2$) + débit ($N_2$)) / débit (gaz inerte) $\geq$ 5, de préférence $\geq$ 8, ou le mélange de gaz réactionnel ne contient pas de gaz inerte.

**5.** Procédé selon l'une quelconque des revendications précédentes, dans lequel le rapport du courant d'évaporateur global, mesuré en ampères, à l'écoulement d'$0_2$, mesuré en cm$^3$/min, est dans la plage de 15:1 à 6:1, de préférence dans la plage de 14:1 à 10:1.

**6.** Procédé selon l'une quelconque des revendications précédentes, dans lequel la tension de polarisation est dans la plage de 20 à 100 V.

**7.** Procédé selon l'une quelconque des revendications précédentes, dans lequel la pression partielle de $O_2$ est dans la plage de 0,01 à 0,1 Pa, de préférence dans la plage de 0,01 à 0,02 Pa.

**8.** Outil de coupe revêtu constitué d'un substrat et d'un revêtement de matériau dur monocouche ou multicouche, le substrat étant choisi parmi le carbure cémenté, le cermet, les céramiques, le nitrure de bore cubique (cBN), le diamant polycristallin (PCD) ou l'acier rapide (HSS), dans lequel le revêtement de matériau dur comprend au moins une couche de $Al_aCr_bMe_cO_dN_e$, dans lequel a, b, c, d et e sont des rapports atomiques et dans lequel

    i)

$$a + b + c + d + e = 1,$$

    ii) a, b, d et e sont chacun > 0,
    iii) c = 0 ou c > 0,
    iv) a $\geq$ b,
    v)

$$c / (a + b + c) \leq 0,1$$

    vi)

$$0,1 \leq d / (d + e) \leq 0,5$$

dans lequel Me est au moins un élément choisi dans le groupe constitué par Ti, Zr, Ta, Nb, Hf, Si et V et la couche de $Al_aCr_bMe_cO_dN_e$ ayant en outre les caractéristiques suivantes :

    - une dureté Vickers HV 0,015 $\geq$ 3000
    - un module de Young réduit E $\geq$ 400 GPa.

**9.** Outil de coupe revêtu selon la revendication 8, dans lequel

$$0,05 \leq b / (a + b + c) \leq 0,5.$$

**10.** Outil de coupe revêtu selon l'une quelconque des revendications 8 et 9, dans lequel

$$2/3 \leq (a + b + c) / (d + e) \leq 1.$$

**11.** Outil de coupe revêtu selon l'une quelconque des revendications 8 à 10, dans lequel la couche de $Al_aCr_bMe_cO_dN_e$ a une dureté Vickers HV 0,015 $\geq$ 3200.

**12.** Outil de coupe revêtu selon l'une quelconque des revendications 8 à 11, dans lequel la couche de $Al_aCr_bMe_cO_dN_e$ a un module de Young réduit E $\geq$ 420 GPa.

**13.** Outil de coupe revêtu selon l'une quelconque des revendications 8 à 12, dans lequel la couche de $Al_aCr_bMe_cO_dN_e$ a une rugosité de surface moyenne Ra, mesurée sur une longueur de 4,8 mm $\leq$ 0,5 $\mu$m, de préférence $\leq$ 0,1 $\mu$m.

**14.** Outil de coupe revêtu selon l'une quelconque des revendications 8 à 13, obtenu dans un procédé selon l'une quelconque des revendications 1 à 7.

XRD of layer type 5006

*Figure 1*

XRD of layer type 7005

*Figure 2*

XRD of layer type 3004

*Figure 3*

XRD of layer type 4002

*Figure 4*

XRD of layer type 5002

_Figure 5_

XRD of layer type 5008

_Figure 6_

XRD of layer type 6004

*Figure 7*

XRD of layer type 7001

*Figure 8*

XRD of layer type 7003

*Figure 9*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009279690 B

- US 2008131727 A

**Non-patent literature cited in the description**

- **KHATIBI A. et al.** *Acta Materialia,* 2012, vol. 60, 6494-6507
- **DIECHLE et al.** *Surf. Coat. Technol.,* 2011, vol. 206, 1545-1551

- **DIECHLE et al.** *Surf. Coat. Technol.,* 2010, vol. 204, 3258-3264
- **ROEBUCK et al.** Measurement Good Practice. National Physical Laboratory, November 1999, 19-20